# EUROPEAN PATENT APPLICATION

(11) **EP 1 512 768 A1**
(43) Date of publication of application: **09.03.2005**
(21) Application number: 03730828.5
(22) Date of filing: 05.06.2003
(51) Int. Cl.: C23C 14/12, C23C 14/24, H05B 33/10, H05B 33/14

(54) **METHOD FOR FORMING ORGANIC THIN FILM**

(30) Priority: 07.06.2002 JP 2002166522
(71) Applicant: Sony Corporation, Tokyo 141-0001 (JP)
(72) Inventor: YANASHIMA, Katsunori, Sony Corporation, Shinagawa-ku, Tokyo 141-0001 (JP); NARUI, Hironobu, Sony Corporation, Shinagawa-ku, Tokyo 141-0001 (JP); MEMEZAWA, Akihiko, Sony Corporation, Shinagawa-ku, Tokyo 141-0001 (JP); SASAKI, Koji, Sony Corporation, Shinagawa-ku, Tokyo 141-0001 (JP)
(74) Representative: Müller, Frithjof E., Dipl.-Ing.
(86) International application number: PCT/JP2003/007117
(87) International publication number: WO 2003/104520

(57) **Abstract**

A method for forming, without heat evolution, an organic thin film with homogeneous quality on the surface of the substrate.

The method consists of vaporizing a single film-forming component of organic material, thereby evolving a film-forming gas (g2), transporting and feeding the film-forming gas (g2) into a reaction chamber (11) in which a substrate (W) is placed, and depositing the organic material, while keeping the film-forming component, on the surface of the substrate (W) in the reaction chamber (11). The substrate (W) is kept cooled while the organic material is being deposited. The film-forming gas (g2) is transported and fed into the reaction chamber (11) by using a carrier gas, such as an inert gas (g1). The deposition of the organic material is repeated so that films differing in composition are formed one over another.

## Description

### Technical Field

The present invention relates to a method for forming an organic thin film and, more particularly, to a method for forming an organic thin film which can be suitably applied to forming an organic thin film constituting an optical element such as organic EL element.

### Background Art

Electroluminescence (EL for short hereinafter) of an organic material is used for an organic EL element which is composed of an anode, a cathode, and an organic layer held between the two electrodes. The organic EL element of this structure emits different colors depending on the material selected for the organic layer. If a plurality of organic EL elements emitting different colors are arranged in a specific manner, it will be possible to construct a display unit capable of multicolor display or full-color display.

Production of such organic EL elements as mentioned above involves vacuum deposition to form the organic layer. Vacuum deposition is one method of depositing a desired material on a substrate by evaporating a material (to be deposited) from a vapor source which is placed under the substrate. In vacuum deposition in this manner, it is necessary to vary the rate of evaporation of the vapor source by adjusting the temperature of the vapor source in order to control the film-forming rate. Unfortunately, the rate of evaporation does not change linearly with temperature. The rate of evaporation even becomes unstable as the temperature changes, and this makes accurate control difficult. Moreover, the rate of evaporation does not respond quickly to the change of temperature, and this results in a long processing time and poor productivity.

In order to replace the conventional film-forming method by vacuum deposition, there has been proposed the organic vapor phase deposition method (OVPD method). See published Japanese translation of PCT international publication for patent application Nos. 2001-523768 and 2000-504298. As disclosed in these official gazettes, OVPD method consists of placing a substrate in a reactor, supplying the reactor with a plurality of organic precursor substances in vapor phase, and causing them to chemically react (or mix) with each other so that their organic reaction products deposit on the surface of the substrate, thereby forming organic thin films sequentially one over another. The organic precursor substances may be donor and acceptor or guest and host for each other.

The OVPD method varies in the film-forming speed depending on the rate at which the organic precursor material is fed into the reactor, and hence it permits the film-forming speed to be controlled more adequately than the vacuum deposition method and achieves rapid film forming.

Unfortunately, the forming of organic thin film by the OVPD method has the following disadvantage. The OVPD method requires that a plurality of organic precursor substances be fed into the reactor in which they chemically react or mix with each other. Therefore, the organic precursor substances do not mix homogeneously in the reactor or there is an uneven temperature distribution in the reactor even in the case of homogeneous mixing. This makes the chemical reaction irregular, which in turn leads to variation in quality of the organic thin film formed on the surface of the substrate.

Moreover, the reaction of the organic precursor substances may evolve reaction heat to deteriorate the organic thin film which has already been formed on the surface of the substrate. Therefore, the OVPD method applied to the production of organic EL elements having organic layers (including an emitting layer) formed by laminating a plurality of organic thin films as mentioned above has the disadvantage that the previously formed organic layer is deteriorated by reaction heat which is evolved when another organic layer is formed later. This leads to elements with inadequate characteristics.

It is an object of the present invention to provide a method for forming, without heat evolution, an organic thin film with homogeneous quality on the surface of the substrate.

### Disclosure of Invention

The invention to achieve the above-mentioned object is directed to a method for forming an organic thin film which includes vaporizing a single film-forming component of organic material, transporting and feeding the resulting gas into a reaction chamber in which a substrate is placed, and depositing the single film-forming component of organic material as such on the surface of the substrate in the reaction chamber.

The above-mentioned method for forming an organic thin film has the advantage that the film deposited on the surface of the substrate is composed solely of the film-forming component of organic material which has been transported and fed into the reaction chamber. Film forming in this manner eliminates inhomogeneous mixing of film-forming components or reaction heat due to reactions between film-forming components.

### Brief Description of Drawings

Fig. 1 is a schematic diagram showing the construction of the film-forming apparatus to form organic thin films according to the present invention.
Fig. 2 is a sectional view showing the construction of the organic EL element produced by the method of the present invention.
Fig. 3 is a sectional view showing a first example of the construction of the emitting layer in the organic EL element produced by the method of the present invention.
Fig. 4 is a sectional view showing a second example of the construction of the emitting layer in the organic EL element produced by the method of the present invention.
Fig. 5 is a sectional view showing a third example of the construction of the emitting layer in the organic EL element produced by the method of the present invention.

### Best Mode for Carrying out the Invention

The invention will be described in more detail with reference to the accompanying drawings.

### [Film-forming apparatus]

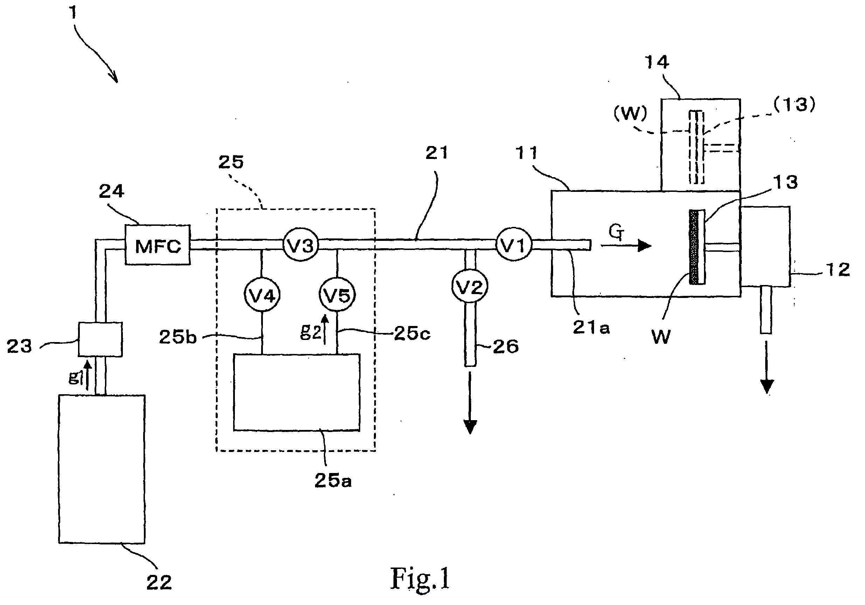

Fig. 1 schematically shows an example of the film-forming apparatus to form organic thin films according to the embodiment of the present invention. The film-forming apparatus 1 is equipped with a reaction chamber 11 to accommodate a substrate W on which organic thin films are to be formed.

The reaction chamber 11 is equipped with an exhaust system 12, which keeps the reaction chamber 11 at a prescribed pressure. The exhaust system 12 is so constructed as to pass the exhaust gas through a trap (not shown) that catches residual materials and discharges only inert gas, such as nitrogen (explained later), through a scrubber.

The reaction chamber 11 is provided with a substrate support 13 to hold a substrate W. It is also provided with a temperature controlling mechanism that keeps the supported substrate W at a prescribed temperature. It is also provided with a drive mechanism that rotates or slides the supported substrate W along its surface.

The reaction chamber 11 is equipped with a load lock chamber 14 in which the substrate W is fixed to the substrate support 13. The load lock chamber 14 is constructed such that the atmosphere therein can be evacuated or replaced with an inert gas as desired. To start operation, the atmosphere in the load lock 14 is replaced with an inert gas and the substrate W is fixed to the substrate support 13. Then, the load lock 14 is evacuated and the gate valve (not shown) between the load lock 14 and the reaction chamber 11 is opened. The substrate support 13 holding the substrate W is moved into the reaction chamber 11 in a prescribed state.

To the reaction chamber 11 is connected a supply pipe 21 through which a gas G is fed into the reaction chamber 11. The supply pipe 21 has a gas inlet 21a at its end. The gas inlet 21a is inserted into the reaction chamber 11 so that it blows the gas G against the substrate held on the substrate support 13 in the reaction chamber 11.

The other end of the supply pipe 21 is connected to a gas purifying apparatus 22 (or gas cylinder) which supplies high-purity inert gas (such as N₂, He, and Ar) or hydrogen as the carrier gas. The supply pipe 21 between the gas purifying apparatus 22 and the reaction chamber 11 is provided with a pressure regulator 23, a mass flow controller (MFC) 24, a raw material supply mechanism 25, a vent line 26 (having a valve V2), and a valve V1.

The raw material supply mechanism 25 is made up of a raw material container 25a, which stores organic materials for organic thin films, a charging pipe 25b, which branches out from the supply pipe 21 and extends to the raw material container 25a, and a discharging pipe 25c, which branches out from the supply pipe 21 (downstream) and extends to the raw material container 25a. There is a valve V3 in the supply pipe 21 between the two points from which the charging pipe 25b and the discharging pipe 25c branch out. There are also valves V4 and V5 in the charging pipe 25b and the discharging pipe 25c, respectively.

When in operation, the film-forming apparatus 1 constructed as mentioned above keeps all the pipes and containers between the mass flow controller 24 and the reaction chamber 11 at a prescribed high temperature. Heating for temperature control may be accomplished by means of any of air bath, oil bath, RF (radio frequency) heater, and lamp heater, which is not specifically restricted.

### [Method for forming organic thin films]

A description is given below of a method for forming organic thin films by using the film-forming apparatus 1 constructed as mentioned above. It is assumed that the organic thin film formed by this method is an electron transporting emitting layer of Alq3 [tris(8-quinolinolato)aluminum (III)], which is commonly used for organic EL elements.

First, a substrate W is fixed to the substrate support 13 in the load lock chamber 14. Then, the load lock chamber 14 is evacuated. The load lock chamber 14 is made to communicate with the reaction chamber 11 (which has previously been evacuated) by opening the valve between them. The substrate support 13 is moved to a prescribed position in the reaction chamber 11. The pressure in the load lock chamber 14 and the reaction chamber 11 should be kept at 133 Pa, for example. The substrate W is kept at about 20°C by means of the temperature controlling mechanism for the substrate support 13. The substrate support 13 is kept rotating or sliding to ensure uniform film formation, if it is provided with the rotating or sliding mechanism.

The raw material container 25a of the raw material supply mechanism 25 is filled with an organic material (Alq3 in this embodiment) as a raw material for the organic thin film. The organic material in the raw material container 25a is heated at a prescribed temperature (280°C for Alq3). This heating keeps the organic material (Alq3) in the gaseous state in the raw material container 25a. Also, all the pipes and containers between the mass flow controller 24 and the reaction chamber 11 should be kept at a prescribed high temperature, say, about 280°C.

Under the state mentioned above, the valves V2 and V3 are closed and the valves V1, V4, and V5 are opened. Then, an inert gas g1 (such as N₂) is fed to the supply pipe 21 at a prescribed pressure of 0.2 MPa, for example, which is controlled by the pressure regulator 23, and at a prescribed flow rate, say, 1000 sccm, which is highly accurately controlled by the mass flow controller 24. ("sccm" stands for standard cc/min, which denotes a flow rate per minute under the standard state.) The inert gas g1 is fed into the raw material container 25a. The inert gas g1, as a carrier gas, is discharged through the discharging pipe 25c, together with the film-forming component gas g2, which is the organic material (Alq3) vaporized in the raw material container 25a. Thus, the inert gas g1 as a carrier gas and the film-forming component gas g2 are fed into the reaction chamber 11 through the supply pipe 21.

In this way the gas G is introduced into the reaction chamber 11 from the gas inlet 21a and is blown against the substrate W fixed to the substrate support 13 in the reaction chamber 11. The gas G contains the organic material (Alq3) as the film-forming component gas g2. The organic material (Alq3) deposits (while keeping its composition) on the surface of the substrate W which is kept at 20°C. Thus, an organic thin film of Alq3 is formed.

The organic thin film has its thickness controlled by the duration of gas feeding to the reaction chamber 11. After the organic thin film has grown to a prescribed thickness, the valves V1, V4, and V5 are closed and the valves V2 and V3 are opened, so that the feeding of the film forming component gas g2 into the reaction chamber 11 is suspended, and the atmosphere in the reaction chamber 11 is replaced with the inert gas g1.

Then, the substrate W and the substrate support 13 are returned to the load lock chamber 14 and the atmosphere in the load lock chamber 14 is restored to normal pressure. The substrate is removed from the load lock chamber 14. In order to prevent the substrate W (with the organic thin film formed thereon) from coming into contact with air, it is recommended that the substrate W be transferred to a special nitrogen-sealed box in the load lock chamber 14 and the nitrogen sealed box be removed from the film forming apparatus 1.

The above-mentioned method for forming an organic thin film is characterized in that the reaction chamber 11 is supplied with the film-forming component gas g2 of organic material with a single composition and an inert gas. Therefore, the organic material deposits, while retaining its composition, to form a film on the surface of the substrate W placed in the reactor chamber 11. Thus, there is no possibility of inhomogeneous component mixing and heat generation due to reactions between components. The result is that the previously formed organic thin film is not deteriorated by reaction heat which would otherwise be generated by the subsequently formed organic thin film. In this way it is possible to form an organic thin film of uniform quality on the surface of the substrate W.

The above-mentioned method for forming an organic thin film is based on the assumption that a single-layer film of Alq3 is formed on the surface of the substrate W. In the case where a plurality of organic thin films are to be formed on the surface of the substrate W, the film forming apparatus is modified such that the section between the reaction chamber 11 and the gas purifying apparatus 22 (or the pressure regulator 23) is multiplied. In other words, one or more supply pipes 21, each having the parts between the mass flow controller 24 and the valve V1, are added. The thus modified film-forming apparatus can sequentially feed film-forming component gases of different organic materials to the reaction chamber 11 through more than one supply pipe 21. Hence, it can form more than one organic thin film continuously one over another.

Forming organic thin films continuously in the above-mentioned manner is illustrated below. The illustrated procedure is an application of the method of the present invention to the production of an organic EL element.

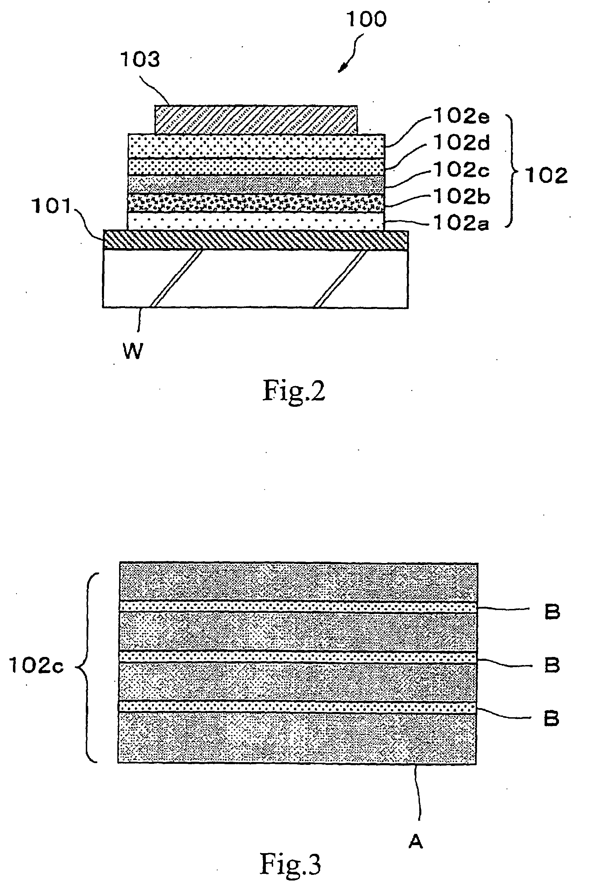

Fig. 2 is a sectional view showing one example of the construction of an organic EL element. The organic EL element 100 consists of a first electrode 101, an organic layer 102, and a second electrode 103, which are sequentially arranged one over another on a substrate W of glass or the like. The first electrode 101 functions as an anode (or cathode) and the second electrode 103 functions as a cathode (or anode), and they are paired with each other.

The organic layer 102 is composed of a hole injecting layer 102a, a hole transporting layer 102b, an emitting layer 102c, an electron transporting layer 102d, and an electron injecting layer 102e, which are sequentially arranged one over another in the direction from the anode (or the first electrode 101) to the cathode (or the second electrode 103). These layers (or organic thin films) 102a to 102e are formed in a pattern from different materials for each color of a light emitting element 5 by the organic EL element 100. Incidentally, the organic layer 102 is not limited to the layer structure mentioned above; it may be in any layer structure so long as it has at least the emitting layer.

The organic EL element 100 formed on the substrate W is enclosed by a protective film and a sealing material (both not shown).

For production of the organic EL element 100 constructed as mentioned above, the foregoing method for forming organic thin films is used to form the organic thin films 102a to 102e which constitute the organic layer 102. The organic thin film layers 102a to 102e can be formed continuously by using the film-forming apparatus 1 (as described above with reference to Fig. 1) which is provided with more than one supply pipe.

If each of the organic thin films 102a to 102e is composed of one organic material as a host and another organic material as a dopant, the foregoing method permits the host layer and the dopant layer to be formed continuously. The resulting organic thin film is constructed such that a dopant is added to a host material as in the case of delta doping.

The host and dopant layers which are sequentially formed are homogeneous in quality because the previously formed lower layer is not thermally affected by the upper layer formed later, as mentioned above. Therefore, it is possible to accurately control the dopant concentration by properly controlling the thickness of the host and dopant layers on the substrate. Thus, the organic thin film layers 102a to 102e can be formed under accurate control.

The fact that the dopant concentration can be accurately controlled by adjusting the thickness of the host and dopant layers permits the organic thin film layers 102a to 102e (or the organic EL element) to be designed more freely.

For example, the emitting layer 102c may have a structure as shown in Fig. 3. Host layers A of prescribed thickness are formed so that they are in contact with the upper and lower layers, and dopant layers B are formed between the host layers A. In this way it is possible to form an organic thin film layer in which a dopant is added only to the center of the host. The resulting organic thin film is exempt from concentration quenching that occurs when the dopant is excessively close to the interface.

Moreover, the above-mentioned layer structure controls the emitting part in the emitting layer 102c according to the position of the dopant layer and hence protects the element from deterioration by self-emission.

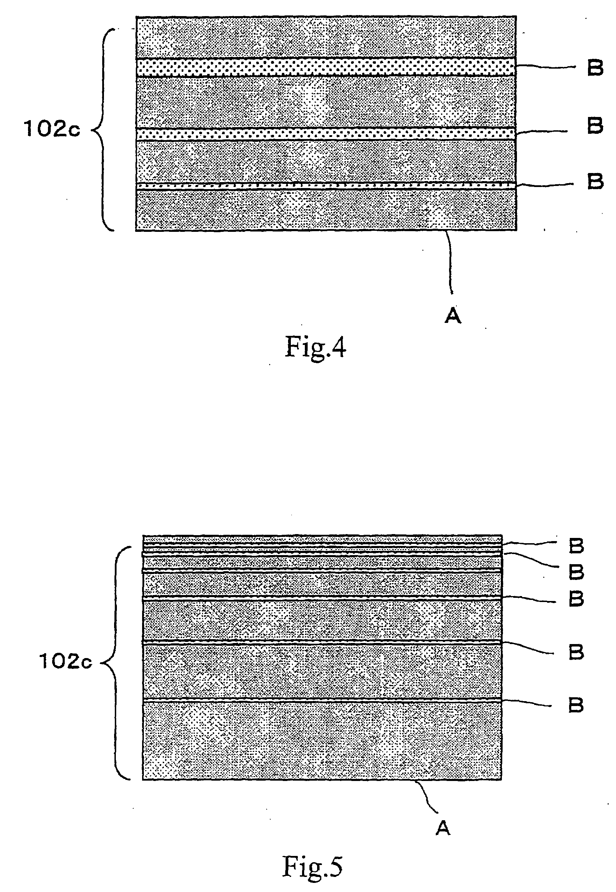

In addition, the above-mentioned layer structure may be modified as shown in Fig. 4. In this case, the dopant layers B between the host layers A vary in thickness, such that the amount of dopant is reduced in the position close to the lower interface and increased in the position close to the upper interface, or vice versa. This contributes to flexible design of organic EL elements.

The above-mentioned layer structure may be modified as shown in Fig. 5. In this case, the dopant layers B between the host layers A remain constant in thickness, but the host layers A vary in thickness. In this way, the effective dopant concentration can be controlled. As in the case shown in Fig. 4, this also contributes to flexible design of organic EL elements.

Each of the organic thin film layers 102a to 102e is formed on the substrate W according to a desired pattern. Therefore, when the organic thin film layers 102a to 102e are formed continuously by using the above-mentioned film-forming apparatus, a mask having openings conforming to pixels is placed on the substrate so that the gas G (which is introduced from the gas inlet 21a into the reaction chamber 11) is blown against the substrate W through the openings of the mask.

Unlike vacuum deposition, the above-mentioned process for forming organic thin films permits the film-forming component gas to be supplied in any direction, thereby obviating the necessity of directing the substrate surface downward. Therefore, it permits the organic thin films to be formed, with the substrate surface and mask held approximately vertical. This produces the effect of preventing the mask (placed above the substrate surface) from bending.

The film-forming apparatus 1 shown in Fig. 1 may be modified such that the reaction chamber 11 has two or more gas inlets 21a which are arranged at uniform intervals. Thus, the various parts of the substrate surface W receive the gas G in the same direction. Supplying the gas G in this manner solves the problem with pattern variation due to shadow effect that occurs in vacuum deposition through a mask. Moreover, the film-forming apparatus constructed as mentioned above forms films with uniform thickness on the substrate surface and hence obviate the necessity of sliding or rotating the substrate support 13. This helps reduce the size of apparatus.

### Industrial Applicability

As mentioned above, the present invention provides a method for forming organic thin films. This method consists of supplying the reaction chamber with a single film-forming component gas of organic material, thereby depositing the organic material on the substrate surface while keeping the gas composition. Therefore, it offers the advantage of forming organic thin films without evolving heat due to reaction between film-forming components. Thus, the resulting organic films have uniform quality without the previously formed lower layer being deteriorated by reaction heat. The method for forming organic thin films can be applied to the production of optical elements, such as organic EL elements, having good characteristic properties.

## Claims

1. A method for forming an organic thin film which comprises vaporizing a single film-forming component of organic material, transporting and feeding the resulting gas into a reaction chamber in which a substrate is placed, and depositing the single film-forming component of organic material as such on the surface of the substrate in the reaction chamber.

2. The method for forming an organic thin film as defined in Claim 1, wherein the substrate is kept cooled while the organic material is being deposited.

3. The method for forming an organic thin film as defined in Claim 1, wherein the deposition of the organic material is repeated so that film-forming components differing in composition are formed one over another.

4. The method for forming an organic thin film as defined in Claim 1, wherein the film-forming gas is transported and fed into the reaction chamber by using a carrier gas.
